# EUROPÄISCHE PATENTSCHRIFT

(11) **EP 1 204 878 B1**
(45) Veröffentlichungstag und Bekanntmachung des Hinweises auf die Patenterteilung: **25.05.2005**
(21) Anmeldenummer: 00951514.9
(22) Anmeldetag: 16.08.2000
(51) Int. Cl.: G01R 33/561, G01R 33/38, G01R 33/54, G01R 33/483, G01N 24/08

(54) **VERFAHREN ZUR ERZEUGUNG VON MESSSIGNALEN IN MAGNETFELDERN**
METHOD FOR GENERATING MEASUREMENT SIGNALS IN MAGNETIC FIELDS
PROCEDE POUR PRODUIRE DES SIGNAUX DE MESURE DANS DES CHAMPS MAGNETIQUES

(30) Priorität: 20.08.1999 DE 19939626
(43) Veröffentlichungstag der Anmeldung: 15.05.2002
(73) Patentinhaber: Blümich, Bernhard, Prof. Dr., 52159 Roetgen (DE)
(72) Erfinder: BLÜMICH, Bernhard, Prof. Dr., D-52159 Roetgen (DE); BLÜMLER, Peter, Canterbury CT 27 RP (GB)
(74) Vertreter: Metz, Siegfried
(86) Internationale Anmeldenummer: PCT/EP2000/007948
(87) Internationale Veröffentlichungsnummer: WO 2001/014900

(56) Entgegenhaltungen:
- US-A- 4 318 043
- US-A- 4 833 411
- US-A- 5 304 930
- ZIMMER G ET AL: "CHARACTERIZATION OF CROSS-LINK DENSITY IN TECHNICAL ELASTOMERS BY THE NMR-MOUSE" SOLID STATE NUCLEAR MAGNETIC RESONANCE,ELSEVIER SCIENCE BV., AMSTERDAM,NL, Bd. 12, Nr. 2-3, 1998, Seiten 183-190, XP000918333 ISSN: 0926-2040
- MCINTYRE D J O ET AL: "SPARE: A ROBUST METHOD FOR MAGNETIC RESONANCE IMAGING IN INHOMOGENEOUS FIELDS" JOURNAL OF MAGNETIC RESONANCE,US,ACADEMIC PRESS, ORLANDO, FL, Bd. 130, Nr. 1, 1998, Seiten 58-62, XP000734664 ISSN: 1090-7807 in der Anmeldung erwähnt
- GUTHAUSEN A ET AL: "Analysis of polymer materials by surface NMR via the MOUSE" JOURNAL OF MAGNETIC RESONANCE, JAN. 1998, ACADEMIC PRESS, USA, Bd. 130, Nr. 1, Seiten 1-7, XP002154163 ISSN: 1090-7807
- COTTRELL S P ET AL: "NMR IMAGING OF SOLIDS USING LARGE OSCILLATING FIELD GRADIENTS" MEASUREMENT SCIENCE AND TECHNOLOGY,GB,IOP PUBLISHING, BRISTOL, Bd. 1, Nr. 7, 1. Juli 1990 (1990-07-01), Seiten 624-629, XP000136659 ISSN: 0957-0233
- MALLETT M J D ET AL: "THREE-DIMENSIONAL NMR IMAGING USING LARGE OSCILLATING FIELD GRADIENTS" JOURNAL OF MAGNETIC RESONANCE. SERIES A,US,ACADEMIC PRESS, ORLANDO, FL, Bd. 119, Nr. 1, 1. März 1996 (1996-03-01), Seiten 105-110, XP000559744 ISSN: 1064-1858
- LIMIN LI: "A NEW TECHNIQUE FOR SOLID NMR IMAGING AND APPLICATION TO PHOSPHORUS IMAGING IN SOLID BONE" PHYSICS IN MEDICINE AND BIOLOGY,GB,TAYLOR AND FRANCIS LTD. LONDON, Bd. 36, Nr. 2, 1. Februar 1991 (1991-02-01), Seiten 199-206, XP000203183 ISSN: 0031-9155

## Beschreibung

Die Erfindung betrifft ein Verfahren zur Erzeugung von Meßsignalen in Magnetfeldern, die von einem NMR-MOUSE-Gerät in dessen Umfeld im Umgebungsmedium erzeugt werden und deren Veränderung zu messen sind. Dabei werden mittels Magneten, beispielsweise Elektro- oder Permanentmagneten, ein zeitlich konstantes Polarisationsfeld *B*₀ und mittels Hochfrequenzschwingkreis gepulst ein magnetisches Meßfeld B, erzeugt und die dabei im Umgebungsmedium verursachten Echosignale S ermittelt. Die Echosignale sind zeitlich nach einer Änderung des Magnetfeldes durch ein oder mehrere vom NMR-MOUSE-Gerät abgegebene Signalimpulse jeweils nach einer Echozeit t_{E} vom NMR-MOUSE-Gerät meßbar. Das Meßsignal wird im Umfeld des NMR-MOUSE-Geräts in dem Magnetfeldbereich erzeugt, in dem die Komponenten der beiden Magnetfelder *B*₀ und *B*₁ orthogonal zueinander stehen.

Das NMR-MOUSE-Gerät (Nuclear Magnetic Resonance - MObile Universal Surface Explorer) ist ein mobiles Meßgerät für kernmagnetische Resonanz, bei dem das erzeugte Magnetfeld und der das Meßsignal abgebende Meßbereich in der äußeren Umgebung des Geräts liegen. Das NMR-MOUSE-Gerät, im folgenden abgekürzt 'NMR-MOUSE' genannt, ist somit zur Ermittlung von Materialdaten aus dem Umgebungsmedium bevorzugt geeignet. Es dient zur Untersuchung räumlicher Strukturen: Sowohl kristalline oder glasige Werkstoffe, als auch weiche Materialien, wie z.B. Elastomere bezüglich ihrer molekularen Dynamik, und Flüssigkeiten sowie biologisches Material sind analysierbar, siehe z.B. G.Eidmann et al, "The NMR MOUSE, a mobile universal surface explorer", Journal of Magnetic Resonance, 1996, S. 104/109, sowie P.Blümler et al, "Spatially resolved magnetic resonance", Wiley-VCH-Verlag, 1998, S. 195/209, oder A. Guthausen et al, "NMR-Bildgebung und Materialforschung", Chemie in unserer Zeit, 1998, S.73/82 und G.Zimmer et al, "Charakterization of Cross-Link Density in Technical Elastomers by the NMR-Mouse", Solid State Nucl.Magn.Res., Bd.12, Nr.2-3, 1998, S.183/190. Das zeitlich konstante, statische magnetische Polarisationsfeld *B*₀ wird bei der NMR-MOUSE meist mittels eines oder mehrerer Permanentmagneten erzeugt, das gepulste magnetische Meßfeld B, ist der magnetische Anteil eines Hochfrequenzfeldes, das mit einer Spule als Bestandteil eines elektrischen Schwingkreises gebildet wird, wobei die Spule gewöhnlich auch als Empfängerspule für die zu messenden Echosignale dient. Bei der NMR-MOUSE wird zur Polarisation der Kernmagnetisierung im permanentmagnetischen Polarisationsfeld *B*o und zur Erzeugung und Detektion der Meßsignale auf räumlich homogene Magnetfelder verzichtet. NMR-MOUSE-Geräte können somit im Verhältnis zu üblichen NMR-Geräten klein und kostengünstig gebaut werden. Dabei definieren Form und Größe des Umgebungsvolumens, das im Umfeld kemmagnetisch impliziert wird und durch Messen der Echosignale zu detektieren ist, einerseits die orthogonalen Komponenten beider Magnetfelder *B*₀ und B₁ und andererseits die spezifische Bandbreite der magnetischen Anregung des zu untersuchenden Materials. Der Verlauf der magnetischen Feldlinien kann durch Dimensionierung und Anordnung der Permanentmagnete und der Spule des elektrischen Hochfrequenzschwingkreises verändert werden.

Der räumliche Meßbereich im zu untersuchenden Umgebungsmedium ist dreidimensional durch Verschieben der NMR-MOUSE, durch Verformen der Magnetfelder über Zusatzspulen und durch Änderung des Hochfrequenzfeldes variierbar. Nachteilig ist bei den bisher konzipierten Geräten dieser Art, daß die Detektion der Echosignale, die im Umgebungsmedium von den Sendesignalen ausgelöst werden, einen hohen Zeitaufwand erfordert. Es fehlt eine ausreichende Ortsauflösung innerhalb des Meßbereichs und die zu messenden Signale selbst zeigen wenig Kontrast zur Unterscheidung unterschiedlicher Werkstoffbeschaffenheit.

Zur Verkürzung der Meßzeit ist es aus DE 195 11 835 C2 bekannt, unter Ausnutzung des gegebenen konstanten Magnetfelds mit frequenzselektiven Hochfrequenzpulsen den Meßbereich abzutasten. Dabei ergibt sich zwar eine schnellere Meßwertausbeute, der erreichbare Kontrast zur Abbildung des untersuchten Mediums genügt jedoch insbesondere für Materialuntersuchungen den zu stellenden hohen Anforderungen nicht.

In US-A-5304930 wird ein NMR-System beschrieben, das ähnlich einer NMR-MOUSE mit Abstand zum zu untersuchenden Objekt eingesetzt wird. Zur Ortskodierung werden bei Anwendung einer CPMG-Sequenz gepulste Zusatzmagnetfelder erzeugt und Echosigmale generiert, die eine Kontrasterhörung ermöglichen.

Aufgabe der Erfindung ist es, in zeitkonstanten inhomogenen Magnetfeldern Meßsignale zu erzeugen, die in einem Meßdurchgang die Detektion mehrerer Raumpunkte im Meßfeld mit problemspezifischem Kontrast ermöglichen.

Diese Aufgabe wird durch die in Patentanspruch 1 angegebenen Maßnahmen gelöst.

Es können so zum einen in einem Meßdurchgang mehrere. Raumpunkte zur Detektion des Umgebungsvolumens gemessen werden, was als "Multiplexvorteil" bezeichnet wird. Zum anderen werden die Echosignale S zur Kontrasterzeugung mit den Impulsen des Hochfrequenzschwingkreises mehrfach refokussiert. Neben dem Multiplexvorteil im Ortsraum ist damit durch Wichtung mit typischen NMR-Parametem (z.B. durch transversale Relaxationszeit) auch ein Multiplexvorteil bei der Kontrastmessung gegeben. Zur Detektion des zu messenden Umfeldes lassen sich daher innerhalb einer Meßzeiteinheit nicht nur eine hohe Anzahl von Meßpunkten abtasten, die Meßpunkte werden zugleich auch mit verstärktem Kontrast ermittelt, so daß für die Analytik mit der NMR-Mouse durch Erzeugung der gepulsten Zusatzmagnetfelder eine erhebliche qualitative Verbesserung gegenüber den bisher bekannten Meßverfahren erreicht ist.

Zur Erzeugung der Hochfrequenzsignale im pulsierenden magnetischen Meßfeld B₁ wird zur Kernmagnetisierung zweckmäßig die Hochfrequenzanregung nach der Methode von Carr, Purcell, Meiboom und Gill, die CPMG-Methode benutzt (siehe Guthausen et al, "Analysis of Materials by Surface NMR via the MOUSE", *J. Magn.Reson*. 130, 1998, S. 1/7). Als Echosignale werden nach Patentanspruch 2 CPMG-Echos erzeugt. Ebenso sind weitere bekannte NMR-Echoverfahren anwendbar und zur Kontrastvariation sinnvoll, mit denen sich Echosignale erzeugen lassen, deren Amplitude weitgehend unabhängig von der Inhomogenität eines anliegenden Permanentmagnetfeldes ist. Der Einfluß auf das Meßsignal, der sich infolge des inhomogenen statischen Magnetfeldes ergibt, wie es beim Polarisationsfeld *B*₀ der NMR-MOUSE gegeben ist, wird auf diese Weise eliminiert. Der Effekt des Zusatzmagnetfeldes *B*_{z} auf das Echosignal S ist somit störungsfreier zu ermitteln.

Die Erfindung wird nachfolgend anhand von schematischen Ausführungsbeispielen näher erläutert. Die Zeichnung zeigt im einzelnen:
- Figur 1: Multiplexverfahren
- Figur 2: Aufbau einer NMR-MOUSE zur Durchführung der erfindungsgemäßen Verfahren mit
Figur 2a: Aufsicht auf eine NMR-MOUSE aus Richtung a nach Figur 2b,
Figur 2b: Längsschnitt durch die NMR-MOUSE gemäß Schnittlinie b nach Figur 2a

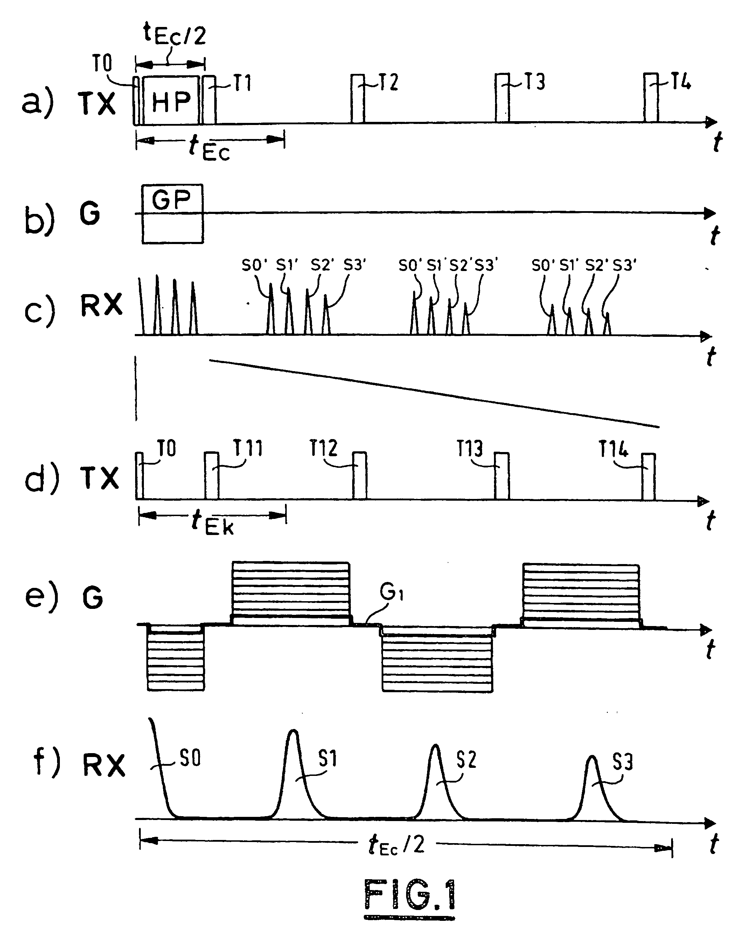

Figur 1 gibt schematisch das Multiplexverfahren wieder und zeigt die Taktfolge zeitlich aufeinander folgender Signalimpulse. In der ersten Zeile a von Figur 1 sind in schematischer Darstellung gepulste Sendesignale TX des Hochfrequenzschwingkreises zur Erzeugung des magnetischen Meßfeldes *B*₁ eingetragen. Unter "Pulsen" der Sendesignale oder "Pulsen" des Hochfrequenzmagnetfeldes wird verstanden, daß das Meßfeld *B*₁ in einem vorgegebenen Zeittakt, im Ausführungsbeispiel im Zeitabstand t_{Ec}, durch Anregen der Hochfrequenzspule über einen kurzen Zeitraum stoßweise erzeugt wird. Auf ein erstes Pulsen des Hochfrequenzschwingkreises mit Sendesignalen TO, T1 im ersten Zeitintervall t_{Ec} /2, das im folgenden als Präparationsperiode bezeichnet wird, folgen anschließend gepulste Sendesignale T2 bis TN des Hochfrequenzschwingkreises jeweils in zeitlichem Abstand t_{Ec} aufeinander. In der zweiten Zeile b von Figur 1 ist schematisch das Gradientensignal *G* zur Erzeugung des Zusatzmagnetfeldes *B*_{z} und in der dritten Zeile c das Empfängersignal RX angegeben, das aufgrund der im Gesamtmagnetfeld gebildeten Echosignale S meßbar ist, die sich durch Überlagerung von konstantem magnetischen, im Ausführungsbeispiel permanentmagnetischem Polarisationsfeld *B*_{0;} gepulstem Meßfeld B₁ und ebenfalls gepulstem Zusatzmagnetfeld *B*_{*z*} (*B*_{*z*} = *G r* mit *r* = Ortsvektor) ergeben. Die unteren drei Zeilen d bis f von Figur 1 zeigen Sende-, Gradienten- und Empfängersignale während der Präparationsperiode abweichend von den ersten drei Zeilen der Figur 1 zeitlich gespreizt. Es sind diejenigen Signale angegeben, die innerhalb des ersten Zeitintervalls t_{Ec} /2 gesendet und empfangen werden. In Zeilen a bis c der Figur 1 sind diese Signale in der Präparationsperiode schematisch als Blöcke eingetragen, so in Zeile a die Sendesignale TX des Hochfrequenzschwingkreises als Block HP (siehe zeitlich gespreizt in Zeile d mit T11, T12, T13, T14) sowie als Block GP das Gradientenfeld G des Zusatzmagnetfeldes *B*_{*z*} mit Vorzeichenänderung des Gradienten (siehe zeitlich gespreizt in Zeile e von Figur 1). Die Sendesignale TX des Hochfrequenzschwingkreises werden in der Präparationsperiode in zeitlichem Abstand im Zeittakt t_{Ek} erzeugt. Das Empfängersignal RX, das sich durch Überlagerung der Magnetfelder *B*₀, *B*₁ und *B*_{z} innerhalb der Präparationsperiode t_{Ec}/2 ergibt, ist in Zeile auseinander gezogen wiedergegeben, wobei als erstes Signal SO das FID (Free Induction Decay)-Signal angegeben ist, das durch das erste Sendesignal TO des Hochfrequenzschwingkreises erzeugt wird. Auf das FID-Signal folgen dann die Echosignale S, nämlich S1 bis S3.

Wie aus Figur 1 ersichtlich ist, wird das Zusatzmagnetfeld *B*_{z}, das im Ausführungsbeispiel durch Vorzeichenumkehr des Gradientenfeldes gebildet wird, nur im ersten Zeitintervall t_{Ec}/2, also während der Präparationsperiode erzeugt. In den nachfolgenden Zeitabschnitten werden die weiteren Echosignale S0' bis S3' aufgrund der Hochfrequenzanregungen T1, T2, T3 ohne erneut eingeschaltetes Zusatzmagnetfeld mit ihren sich entsprechend der Relaxationszeit abschwächenden Amplitudenwerten gemessen, siehe Figur 1, Zeile c. Die Echosignale S' können bei der Bildgebung so zur Kontrasterzeugung genutzt werden.

Im Ausführungsbeispiel wird zur Hochfrequenzanregung der Kemmagnetisierung im Meßfeld *B*₁ die CPMG-Methode benutzt. Der Einfluß der zeitlich konstanten Inhomogenitäten des von den Permanentmagneten der NMR-MOUSE erzeugten Polarisationsfeldes *B*₀ auf die zu empfangenden Echosignale S wird somit eliminiert. Das Zusatzmagnetfeld *B*_{z} wird zeitlich so geschaltet, daß sein Effekt auf das Echosignal erhalten bleibt. Hierzu ist für das Zusatzmagnetfeld innerhalb des Zeitintervalls t_{Ec}/2 eine Vorzeichenumkehr vorgesehen, wie sie in Zeile e der Figur 1 wiedergegeben ist. Es wird somit bei einfachem Gradientenfeld mit jedem Echo in der CPMG-Folge eine weitere Ortsinformation im zum Ortsraum Fourierkonjugierten Wellenvektorraum oder *k*-Raum erhalten. Werden wie im Ausführungsbeispiel in Gegenwart von hochfrequenten Sendeimpulsen TX innerhalb der Präparationsperiode zusätzlich Gradienten G aufgeschaltet und zusätzlich zum FID-Signal S0 drei CPMG-Echos S1 bis S3 erzeugt, dann werden im zweiten und allen weiteren Zeitintervallen t_{Ec} mit den Echos S0' bis S3', wie sie in Zeile c schematisch angegeben sind, im *k*-Raum jeweils vier Raumpunkte gemessen. Diese innerhalb der Echozeit t_{Ec} erzeugten vier CPMG-Echos werden wie oben angegeben bei ausgeschaltetem Gradientenfeld wiederholt abgerufen. Ihre Ortskodierung über den *k*-Raum wird zur Definition des Kontrastes genutzt. Wieviel aufeinander folgende Zeitintervalle zur Bestimmung von Raumpunkten genutzt werden können, kommt auf die Überdeckung der Echosignale durch jeweils gegebenes instrumentelles Rauschen an.

Im Ausführungsbeispiel nach Figur 1 werden vier Werte des *k*-Raumes mit konstantem Amplitudenwert für die Gradientenpulse *G* (siehe Figur 1, Zeile e, fett markierter Gradientenwert *G*₁) abgefragt, nämlich *k*=0, *k*₁, 2*k*₁, 3*k*₁. Weitere Werte des *k*-Raumes erhält man durch Wiederholung dieses Meßverfahrens mit anderen Werten der Gradientenpulse *G*, die beispielsweise entsprechend der in Figur 1 in Zeile e für steigende Gradientenwerte *G* eingetragenen Pfeilrichtung bestimmt werden.

Zur Erzeugung der Echozüge können verschiedene Verfahren eingesetzt werden, z.B. 180°-Impulse nach Hahn, wie sie in der CPMG-Sequenz Verwendung finden. Aber auch Impulse für dipolare Echos sind nutzbar, siehe hierzu Guthausen et al, wie oben zitiert. Je nach Art der Signalgebung ergibt sich jeweils eine unterschiedliche Signalwichtung und damit unterschiedlicher Kontrast.

Durch die Erzeugung von mehrfachen Echos, die anteilig den Charakter von Hahn-Echos haben, wird die Messung unabhängig von zeitlich konstanten Inhomogenitäten der Permanentmagnetfelder. Es können somit teure Magnete zur Ausbildung homogener Magnetfelder entfallen. In einem Meßdurchgang werden mehrere Raumpunkte im *k*-Raum gemessen. Im gleichen Durchgang werden diese Punkte mit Kontrast mehrfach gewichtet. In dieser Weise ähnelt das Verfahren der SPARE-Methode (Single-Point imAging with Relaxation Enhancement, siehe D.J.O.McIntyre et al, "A Robust Method for Magnetic Resonance Imaging in Inhomogeneous Fields", J. Magn.Reson.130, 1998, S.58/62).

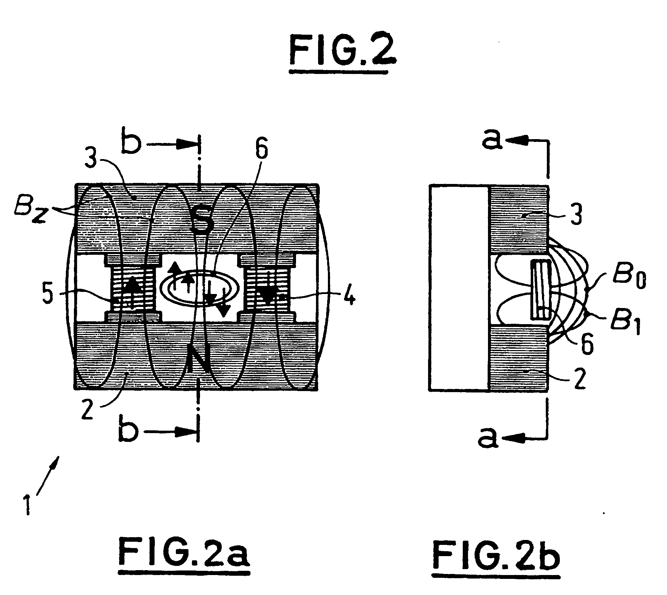

In Figur 2 ist schematisch eine NMR-MOUSE wiedergegeben, die zur Durchführung des vorbeschriebenen erfindungsgemäßen Verfahrens geeignet ist.

Die NMR-MOUSE weist zur Polarisation der kernmagnetischen Momente im zu untersuchenden Material und zur Erzeugung von Meßsignalen räumlich inhomogene Magnetfelder auf. Wie aus Figur 2 ersichtlich ist, befinden sich bei einer NMR-MOUSE 1 zwischen zwei entgegengesetzt magnetisierten Permanentmagneten 2, 3 mit Permanentmagnetpolen N und S zwei Gradientenspulen 4, 5 sowie zwischen den Gradientenspulen eine Hochfrequenzspule 6. Dem statischen Polarisationsfeld *B*₀, das zwischen den Permanentmagnetpolen erzeugt wird, ist mittels der Hochfrequenzspule 6 in zeitlichem Abstand pulsierend ein magnetisches Meßfeld *B*₁ als magnetischer Anteil eines Hochfreqenzfeldes überlagerbar, das mit der Hochfrequenzspule als Bestandteil eines elektrischen Schwingkreises gebildet und empfangen wird. Zum "Pulsen" des magnetischen Meßfeldes B, wird das Magnetfeld in einem vorgegebenen Zeittakt durch Anregen der Hochfrequenzspule über einen kurzen Zeitraum stoßweise erzeugt. Mit den Gradientenspulen 4, 5 wird - ebenfalls gepulst - dem Magnetfeld als Zusatzmagnetfeld *B*_{*z*} ein magnetisches Gradientenfeld überlagert. In Figur 3a sind die Feldlinien des von den Gradienten erzeugten Zusatzmagnetfeldes *B*_{*z*} schematisch eingetragen. Form und Größe des . Umgebungsvolumens, das in der äußeren Umgebung der NMR-MOUSE kemmagnetisch impliziert und durch Messen der Echosignale zu detektieren, ist und so den meßempfindlichen Volumenbereich darstellt, ist für jedes Gerät einerseits durch die spezifische Bandbreite der magnetischen Hochfrequenzanregung und andererseits durch die orthogonalen Komponenten beider Magnetfelder *B*₀ und *B*₁ definiert. Der Verlauf der magnetischen Feldlinien und damit die Größe des signalgebenden Volumenbereichs kann durch entsprechendes Dimensionieren und Anordnen der Permanentmagnete und der Spule des elektrischen Hochfrequenzschwingkreises sowie durch. Zuschalten von Zusatzspulen verändert werden.

Zum permanentmagnetischen Polarisationsfeld *B*₀ wird mittels der Gradientensspulen 4, 5 somit ein Zusatzmagnetfeld *B*_{z} mit einem Feldgradienten tangential zur äußeren Oberfläche der NMR-MOUSE 1 und senkrecht zum Polarisationsfeld *B*₀ erzeugt.
Dieses Zusatzmagnetfeld wird zur Erzeugung der Ortsauflösung (Phasenkodierung der Ortsinformation) in zeitlichem Abstand gepulst. Die Hochfrequenzspule 6 ist in der Weise angeordnet, daß die Feldlinien des Polarisationsfeldes *B*₀ und die Feldlinien des durch die Hochfrequenzspule erzeugten magnetischen Meßfeldes B, im messempfindlichen Volumenbereich senkrecht aufeinander stehen. Die orthogonalen Komponenten der beiden Magnetfelder *B*₀ und B₁ indizieren das Meßsignal. Für Anregung und Detektion des Messignals wird die gleiche Hochfrequenzspule verwendet.

Für die Ausführungsbeispiele sind in der Zeichnung die Magnetfelder und erzeugten Signalimpulse nur eindimensional in einer der Raumrichtungen wiedergegeben. Die Magnetfelder überlagern sich jedoch selbstverständlich in allen drei gegebenen Raumrichtungen. Mit weiteren Spulen können Zusatzmagnetfelder mit Gradienten in den anderen Raumrichtungen für 2dimensionale und 3dimensionale Ortsauflösung erzeugt werden. Die Echosignale sind dementsprechend dreidimensional abrufbar und die beschriebenen Meßmethoden auf 2 und 3 Ortskoordinaten erweiterbar.

### Bezugszeichenliste (Figur 2)

- NMR-MOUSE-Gerät: 1
- Permanentmagnete: 2, 3
- Gradientenspule: 4, 5
- Hochfrequenzspule: 6
- Polarisationsfeld: *B*₀
- magnetisches Meßfeld: *B*₁
- Zusatzmagnetfeld: *B*_{Z}

## Patentansprüche

1. NMR-Verfahren zur Erzeugung von Messsignalen in einem zu untersuchenden Material,
wobei mittels eines NMR-MOUSE-Geräts ein statisches magnetisches Polarisationsfeld Bₒ
und gepulst ein Hochfrequenzmagnetfeld B₁ in dem Material erzeugt werden, wobei durch das Zusammenwirken von Polarisationsfeld und
Hochfrequenzmagnetfeld im Material Echosignale ermittelt werden, und mittels eines ersten Hochfrequenzimpulses (T0) eine transversale Magnetisierung in dem Material angeregt wird, die mittels weiterer Hochfrequenzimpulse (T11,T12,T13) mehrfach unter Erzeugung von Echosignalen (S0,S1,S2,S3) refokussiert wird, **dadurch gekennzeichnet,**
**dass** zwischen jeweils zwei aufeinanderfolgenden Impulsen ein magnetisches Gradientenfeld zur räumlichen Kodierung mit der NMR-MOUSE erzeugt wird, und die Polarität des Gradientenfeldes nach jedem Hochfrequenzimpuls gewechselt wird, und die Gesamtheit der solchermassen in einem Zeitintervall tEc/2 mittels der in diesem Intervall aufeinanderfolgenden refokussierenden Hochfrequenzimpulse erzeugten Echosignale mittels mehrerer zusätzlicher Refokussierimpulse (T1,T2,T3,T4), zwischen denen keine gepulsten Gradientenfelder angelegt werden, mehrfach refokussiert wird unter Bildung von korrespondierenden Echosignalen in aufeinanderfolgenden Zeitintervallen tEc, welche ausgelesen werden.

2. Verfahren nach Patentanspruch 1, **dadurch gekennzeichnet, dass** als Echosignale CPMG-Echos erzeugt werden.

## Claims

1. An NMR method for generating measurement signals in a material to be inspected,
a static polarizing magnetic field B₀ and a pulsed high-frequency magnetic field B₁ being generated in said material using an NMR-MOUSE apparatus,
echo signals being detected in the material through the cooperation between the polarizing field and the high-frequency magnetic field, and transversal magnetization being induced in the material by means of a first high-frequency pulse (TO), said transversal magnetization being repeatedly refocused by means of additional high-frequency pulses (T11, T12, T13), thereby generating echo signals (S0, S1, S2, S3), **characterized in that**
a magnetic gradient field for spatial coding using the NMR-MOUSE is produced between two successive pulses and that the polarity of the gradient field is changed after each high-frequency pulse and that the totality of the echo signals thus produced in a time interval tEc/2 by means of the refocusing high-frequency pulses following each other within said interval is repeatedly refocused by means of a plurality of additional refocusing pulses (T1, T2, T3, T4) between which no pulsed gradient fields are applied, corresponding echo signals forming thereby in successive time intervals tEc and being read out.

2. The method of patent claim 1, **characterized in that** the echo signals generated are CPMG echoes.

## Revendications

1. Procédé RMN destiné à produire des signaux de mesure dans un matériau qu'il y a lieu de contrôler,
selon lequel on produit dans le matériau un champ magnétique de polarisation statique B₀ et un champ magnétique de haute fréquence pulsé B₁ au moyen d'un instrument NMR MOUSE,
on recueille des échos dans le matériau grâce à la coopération entre le champ de polarisation et le champ magnétique de haute fréquence et on induit une magnétisation transversale dans le matériau au moyen d'une première impulsion de haute fréquence (T0), cette magnétisation transversale étant refocalisée à plusieurs reprises au moyen d'impulsions de haute fréquence supplémentaires (T11, T12, T13), ce qui produit des échos (S0, S1, S2, S3), **caractérisé en ce qu'**on produit entre deux impulsions qui se succèdent un gradient de champ magnétique pour le codage spatial à l'aide de l'instrument NMR MOUSE et qu'on change la polarité du gradient de champ après chaque impulsion de haute fréquence et qu'on refocalise à plusieurs reprises la totalité des échos produits de cette façon dans un intervalle de temps tEc/2 au moyen des impulsions de refocalisation haute fréquence (T1, T2, T3, T4) se succédant dans cet intervalle et entre lesquelles on n'applique pas de gradients de champ pulsés, ce qui provoque, dans des intervalles de temps consécutifs tEc, la formation d'échos correspondants qui sont visualisés.

2. Procédé selon la revendication 1, **caractérisé en ce que** les échos produits sont des échos CPMG.
